Europäisches Patentamt

European Patent Office

Office européen des brevets

(19)

(11) Veröffentlichungsnummer: **0 268 249**
**A2**

(12) **EUROPÄISCHE PATENTANMELDUNG**

(21) Anmeldenummer: 87116897.7

(51) Int. Cl.⁴: **H01L 25/14** , H01L 25/08

(22) Anmeldetag: 16.11.87

(30) Priorität: 17.11.86 DE 3639236

(43) Veröffentlichungstag der Anmeldung:
25.05.88 Patentblatt 88/21

(84) Benannte Vertragsstaaten:
DE FR GB IT

(71) Anmelder: Siemens Aktiengesellschaft Berlin
und München
Wittelsbacherplatz 2
D-8000 München 2(DE)

(72) Erfinder: Einzinger, Josef, Dipl.-Ing.
Am Weiher 21
D-8044 Unterschleissheim(DE)
Erfinder: Leipold, Ludwig, Dipl.-Ing.
Strassberger Strasse 125
D-8000 München 40(DE)
Erfinder: Tihanyi, Jenö, Dr.
Windeckstrasse 1d
D-8000 München 70(DE)
Erfinder: Weber, Roland, Dipl.-Ing.
Ursulastrasse 5
D-8000 München 40(DE)

(54) **Leistungs-MOSFET mit Stromerfassung.**

(57) Dem Leistungs-MOSFET (1) ist die Reihenschaltung aus einem weiteren MOSFET (3) mit vergleichsweise kleiner Fläche und einem Widerstand
(5) parallel geschaltet. Der weitere MOSFET und der
Widerstand sind in eine integrierte, zur Ansteuerung
des Leistungs-MOSFET vorgesehene Schaltung integriert.

FIG 1

EP 0 268 249 A2

## Leistungs-MOSFET mit Stromerfassung

Die Erfindung bezieht sich auf ein Leistungs-MOSFET mit einer Vielzahl von parallel geschalteten Einzel-MOSFET, mit mindestens einem weiteren MOSFET mit einer gegenüber der Fläche des Leistungs-MOSFET kleinen Fläche, dem sourceseitig ein Widerstand in Reihe geschaltet ist, wobei die Reihenschaltung dem Leistungs-MOSFET parallel geschaltet ist.

Ein Leistungs-MOSFET dieser Art wurde z. B. in der Zeitschrift "Electronic Design", 20. Februar 1986, Seiten 59 und 60 beschrieben. Hier sind einige des aus einer Vielzahl von parallel geschalteten Einzel-MOSFET bestehenden Leistungs-MOSFET sourceseitig vom Leistungs-MOSFET getrennt. Den Einzel-MOSFET ist sourceseitig ein Widerstand in Reihe geschaltet, durch den ein Strom fließt, der dem durch den Leistungs-MOSFET fließenden Strom proportional ist. Die am Widerstand abfallende Spannung ist dann dem Strom durch den Leistungs-MOSFET proportional. Damit läßt sich die genannte Spannung zur Überwachung des Transistorstroms ausnutzen. Da zur Überwachung lediglich ein Bruchteil des Transistorstroms herangezogen wird, ist die im Widerstand umgesetzte Verlustleistung relativ gering.

Der beschriebene, zur Stromerfassung geeignete Leistungs-MOSFET erfordert gegenüber einem normalen Leistungs-MOSFET mit im übrigen gleichen elektrischen Eigenschaften einen Neuentwurf. Dies ist mit zusätzlichen Kosten verbunden.

Der Erfindung hat das Ziel, den Strom bei einem Leistungs-MOSFET der erwähnten Art dann einfacher zu erfassen, wenn dieser durch eine integrierte Steuerschaltung angesteuert wird. Hierbei handelt es sich um Leistungs-MOSFET, die als sogenannte "Smart-FET" oder unter ähnlichen Bezeichnungen in den Handel gekommen sind.

Diese Aufgabe wird dadurch gelöst, daß der weitere MOSFET und der Widerstand in den vom Halbleiterkörper des Leistungs-MOSFET getrennten Halbleiterkörper einer integrierten, zur Steuerung des Leistungs-MOSFET vorgesehenen Schaltung integriert ist.

Weiterbildungen sind Gegenstand der Unteransprüche.

Die Erfindung wird anhand zweier Ausführungsbeispiele in Verbindung mit den Figuren 1 bis 3 näher erläutert. Es zeigen

Figur 1 die Prinzipschaltung gemäß der Erfindung,

Figur 2 die Seitenansicht und einen teilweisen Schnitt durch einen Leistungs-MOSFET gemäß einem ersten Ausführungsbeispiel und

Figur 3 eine der Figur 2 entsprechende Seitenansicht eines zweiten Ausführungsbeispiels.

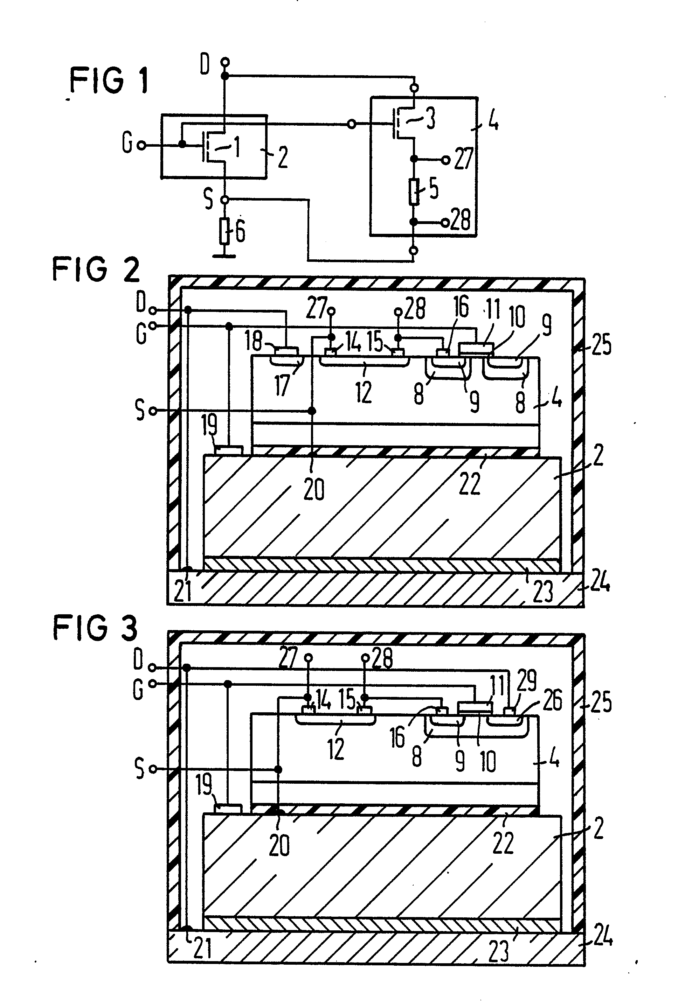

In Figur 1 ist der Leistungs-MOSFET mit 1 bezeichnet. Er hat einen Sourceanschluß S, einen Drainanschluß D und einen Gateanschluß G. Er ist Bestandteil eines Halbleiterköpers 2 und ist hier lediglich symbolisch dargestellt. Der Source-Drainstrecke des Leistungs-MOSFET 1 ist die Reihenschaltung aus einem weiteren MOSFET 3 und einem Widerstand 5 parallel geschaltet. Der MOSFET 3 und der Widerstand 5 ist in einen Halbleiterkörper 4 integriert. Der MOSFET 3 und der Widerstand 5 ist ebenfalls nur symbolisch dargestellt. Der weitere MOSFET 3 hat gegenüber dem Leistungs-MOSFET 1 eine wesentlich geringere Fläche. Diese kann beispielsweise bei einem tausendstel bis einem zweitausendstel der Fläche des Leistungs-MOSFET 1 liegen. Wenn der weitere MOSFET 3 im Aufbau denjenigen Einzel-MOSFET identisch ist, aus denen der Leistungs-MOSFET 1 besteht, wird der weitere MOSFET 3 von einem tausendstel bzw. einem zweitausendstel des durch den Leistungs-MOSFET 1 fließenden Stroms durchflossen. Dem Leistungs-MOSFET 1 ist sourceseitig eine Last 6 in Reihe geschaltet. Die Gateanschlüsse beider MOSFET sind miteinander verbunden.

Zur Überwachung des durch den Leistungs-MOSFET 1 fließenden Stroms wird die Spannung am Widerstand 5 z. B. an zwei Klemmen 27, 28 abgegriffen und z. B. einem Regler zugeführt. Bei Übersteigen einer festgelegten Spannung kann dieser dann die Gate-Sourcevorspannung des Leistungs-MOSFET 1 so einstellen, daß die Spannung am Widerstand 5 und damit der Strom durch den MOSFET 1 abnimmt. Der Regler ist zweckmäßigerweise ebenfalls in den Halbleiterkörper 4 integriert. Der Halbleiterkörper 4 kann daneben noch weitere integrierte Schaltungsanordnungen, z. B. zur Überwachung der Temperatur des Leistungs-MOSFET, Überwachung auf Lastausfall, Überspannung usw. enthalten. Anstelle des Reglers kann auch eine einfache Anzeigevorrichtung vorhanden sein.

Der weitere MOSFET muß nicht unbedingt dem Aufbau einer der Einzel-MOSFET des Leistungs-MOSFET identisch sein. Da er Bestandteil einer integrierten Schaltung ist, die andere Prozeßschritte erfordert als ein Leistungs-MOSFET, wird der weitere MOSFET 3 daher im allgemeinen anders dimensioniert sein. Bei der Dimensionierung ist davon auszugehen, daß seine Gate-Sourcespannung um den Spannungsabfall am Widerstand 5 geringer ist als die Gate-Sourcespannung am Leistungs-MOSFET 1. Im übrigen ist der FET 3 und der Widerstand 5 so zu dimensionieren, daß die am Widerstand abfallende Spannung so groß ist, daß die an den Klemmen 27, 28 angeschlossene Überwachungseinrichtung oder der Regler zwischen Normalbetrieb und Überlastung unterscheiden kann.

Beim Leistungs-MOSFET nach Figur 2 ist der Halbleiterkörper 4 auf dem Halbleiterkörper 2 des Leistungs-MOSFET 1 angeordnet. Die integrierte Schaltung ist stark vereinfacht dargestellt und zeigt lediglich den MOSFET 3 und den Widerstand 5.

In den Halbleiterkörper 4 sind Wannen 8 des dem Halbleiterkörper 4 entgegengesetzten Leitungstyps eingebettet. In diese Wannen 8 ist jeweils eine Sourcezone 9 vom den Wannen 8 entgegengesetzten Leitungstyp eingebettet. Die Sourcezone 9 ist mit einem Kontakt 16 versehen und ist teilweise mit einer Isolierschicht 10 bedeckt, auf der eine Gateelektrode 11 angeordnet ist. Die Wanne 8 bildet mit der Sourcezone 9 und der Gateelektrode 11 und einem Teil des Halbleiterkörpers den weiteren MOSFET 3. In die Oberfläche des Halbleiterkörpers ist eine Widerstandszone 12 eingebettet, die vom dem Halbleiterkörper 4 entgegengesetzten Leitungstyp ist. Sie bildet den Widerstand 5. Die Zone 12 ist an ihren Enden mit Kontakten 14, 15 versehen, die ihrerseits mit den Klemmen 27, 28 verbunden sind. Der Kontakt 15 ist elektrisch mit dem Kontakt 16 verbunden. In die Oberfläche des Halbleiterkörpers 4 ist eine weitere Zone 17 eingebettet, die verglichen mit dem Halbleiterkörper stark dotiert ist. Sie ist mit einer Elektrode 18 kontaktiert. Der Halbleiterkörper 4 ist mit dem Halbleiterkörper 2 des Leistungs-MOSFET durch eine Isolierschicht 22, z. B. durch einen Isolierkleber, verklebt.

Der Halbleiterkörper 2 hat eine Gateelektrode 19 und eine Sourceelektrode 20. Die Gateelektrode 19 ist über eine Leitung mit der Gateelektrode 11 des MOSFET 3 verbunden und führt zu einem Gehäuseanschluß G. Die Sourceelektrode 20 ist mit dem Kontakt 14 verbunden und führt zu einem Gehäuseanschluß S. Der Halbleiterkörper 2 ist über eine wärmeleitende Schicht 23 mit einer metallenen Bodenplatte 24 verbunden. Die Bodenplatte ist mit einer Drainelektrode 21 versehen, an der das Drainpotential für den Leistungs-MOSFET anliegt. Die Drainelektrode 21 ist mit der Elektrode 18 verbunden und führt zu einem Gehäuseanschluß D.

Die Funktionsweise entspricht der Schaltungsanordnung nach Figur 1. Der weitere MOSFET ist hier ein Vertikal-MOSFET.

In der Anordnung nach Figur 3 ist als weiterer MOSFET ein Lateral-MOSFET verwendet, der eine in eine Wanne 8 eingebettete Drainzone 26 hat. Diese ist über einen Kontakt 29 mit der Drainelektrode 21 und dem Drainanschluß D verbunden. Die Zone 17 und der Kontakt 18 erübrigt sich hier, da das Drainpotential direkt an der Drainzone 26 liegt.

Der Halbleiterkörper 4 der Steuerschaltung hat in den gezeigten Ausführungsbeispielen eine kleinere Fläche als der Halbleiterkörper 2 und ist auf einer seiner Oberflächen angeordnet. Der Halbleiterkörper 4 kann jedoch auch räumlich getrennt neben dem Halbleiterkörper 2 auf der Bodenplatte 24 angeordnet sein.

Der Leistungs-MOSFET ist zusammen mit der Ansteuerschaltung und dem zur Stromüberwachung vorgesehenen weiteren MOSFET in einem Gehäuse 25 angeordnet, das hier nur schematisch dargestellt ist. Ebenso sind die Anschlüsse D, G, und S lediglich schematisch dargestellt. Das Gehäuse kann weitere Anschlüsse zur Ein-und Ausgabe von Signalen an die integrierte Steuerschaltung aufweisen. Die die beiden Halbleiterkörper verbindenden Leitungen liegen alle innerhalb des Gehäuses.

## Ansprüche

1. Leistungs-MOSFET mit einer Vielzahl von parallel geschalteten Einzel-MOSFET, mit mindestens einem weiteren MOSFET mit einer gegenüber der Fläche des Leistungs-MOSFET kleinen Fläche, dem sourceseitig ein Widerstand in Reihe geschaltet ist, wobei die Reihenschaltung dem Leistungs-MOSFET parallel geschaltet ist, **dadurch gekennzeichnet,** daß der weitere MOSFET (3) und der Widerstand in den vom Halbleiterkörper (2) des Leistungs-MOSFET (1) getrennten Halbleiterkörper (4) einer integrierten, zur Steuerung des Leistungs-MOSFET vorgesehenen Schaltung integriert ist.

2. Leistungs-MOSFET nach Anspruch 1, **dadurch gekennzeichnet,** daß der Halbleiterkörper (4) der Steuerschaltung eine kleinere Fläche als der Halbleiterkörper (2) des Leistungs-MOSFET (1) hat und auf einer Hauptfläche des Halbleiterkörpers (2) des Leistungs-MOSFET angeordnet ist.

3. Leistungs-MOSFET nach Anspruch 1 oder 2, **dadurch gekennzeichnet,** daß beide Halbleiterkörper in ein und demselben Gehäuse (25) angeordnet sind und daß die Reihenschaltung dem Leistungs-MOSFET durch innerhalb des Gehäuses liegende Leitungen parallel geschaltet ist.

FIG 1

FIG 2

FIG 3